# EUROPÄISCHE PATENTANMELDUNG

(11) **EP 1 906 460 A2**
(43) Veröffentlichungstag der Anmeldung: **02.04.2008**
(21) Anmeldenummer: 07013824.3
(22) Anmeldetag: 13.07.2007
(51) Int. Cl.: H01L 33/00

(54) **Halbleiterkörper und Halbleiterchip mit einem Halbleiterkörper**

(30) Priorität: 27.09.2006 DE 102006045700; 07.12.2006 DE 102006057747
(71) Anmelder: OSRAM Opto Semiconductors GmbH, 93055 Regensburg (DE)
(72) Erfinder: Wirth, Ralph, Dr., 93186 Pattendorf-Adlersberg (DE)
(74) Vertreter: Epping - Hermann - Fischer

(57) **Zusammenfassung**

Es wird ein Halbleiterkörper (2), der eine Halbleiterschichtenfolge mit einem zur Strahlungserzeugung geeigneten aktiven Bereich (3) umfasst, angegeben, wobei die Halbleiterschichtenfolge zwei Kontaktschichten (6, 7) umfasst, zwischen denen der aktive Bereich angeordnet ist, den Kontaktschichten jeweils eine auf dem Halbleiterkörper angeordnete Anschlussschicht (12, 13) zugeordnet ist, die jeweilige Anschlussschicht mit der zugeordneten Kontaktschicht elektrisch leitend verbunden ist, die jeweilige Anschlussschicht auf der von dem aktiven Bereich abgewandten Seite der zugeordneten Kontaktschicht angeordnet ist, die Anschlussschichten für die in dem aktiven Bereich zu erzeugende Strahlung durchlässig sind, und die Kontaktschichten vom gleichen Leitungstyp sind.

## Beschreibung

Die vorliegende Erfindung betrifft einen Halbleiterkörper und einem Halbleiterchip mit einem Halbleiterkörper.

Diese Patentanmeldung beansprucht die Priorität der deutschen Patentanmeldungen 10 2006 045 700.5 vom 27. September 2006 und 10 2006 057 747.7 vom 7. Dezember 2006, deren gesamter Offenbarungsgehalt hiermit explizit durch Rückbezug in die vorliegende Anmeldung aufgenommen wird.

Eine Aufgabe der vorliegenden Erfindung ist es, einen vereinfacht mit hoher Effizienz ausbildbaren, zur Strahlungsemission geeigneten Halbleiterkörper anzugeben. Insbesondere soll ein hinsichtlich des Strahlungsauskopplung effizienter Halbleiterkörper bzw. ein effizienter Halbleiterchip mit einem derartigen Halbleiterkörper angegeben werden.

Diese Aufgabe wird durch einen Halbleiterkörper beziehungsweise einen Halbleiterchip mit den Merkmalen der unabhängigen Patentansprüche gelöst. Vorteilhafte Ausgestaltungen und Weiterbildungen der Erfindung sind Gegenstand der abhängigen Patentansprüche.

Ein erfindungsgemäßer Halbleiterkörper umfasst eine Halbleiterschichtenfolge mit einem zur Strahlungserzeugung geeigneten aktiven Bereich. Weiterhin umfasst die Halbleiterschichtenfolge zwei Kontaktschichten, zwischen denen der aktive Bereich angeordnet ist, wobei den Kontaktschichten jeweils eine auf dem Halbleiterkörper angeordnete Anschlussschicht zugeordnet ist. Die jeweilige Anschlussschicht ist mit der dieser Anschlussschicht zugeordneten Kontaktschicht elektrisch leitend verbunden und auf der von dem aktiven Bereich abgewandten Seite der dieser Anschlussschicht zugeordneten Kontaktschicht angeordnet. Die Anschlussschichten sind ferner für die in dem aktiven Bereich zu erzeugende Strahlung durchlässig, wobei die Kontaktschichten vom gleichen Leitungstyp, insbesondere für den gleichen Leitungstyp dotiert, sind.

Zweckmäßigerweise ist der aktive Bereich und weitergehend der gesamte Halbleiterkörper zwischen den Anschlussschichten angeordnet.

Die Kontaktschichten im Halbleiterkörper sind vorzugsweise für die elektrische Kontaktbildung zum Halbleiterkörper mittels der der jeweiligen Kontaktschicht zugeordneten Anschlussschicht ausgebildet. Die Anschlussschichten sind vorzugsweise als gesonderte Schichten, also auf den vorgefertigten Halbleiterkörper aufgebrachte Schichten, ausgeführt. Die Anschlussschichten sind in diesem Falle insbesondere nicht in dem Halbleiterkörper integriert. Beispielsweise sind die Anschlussschichten auf einen epitaktisch gewachsenen Halbleiterkörper nach beendeter Epitaxie aufgebracht. Für das Aufbringen der Anschlussschichten kann insbesondere ein von dem Herstellungsverfahren für den Halbleiterkörper verschiedenes Verfahren eingesetzt werden.

Ein Halbleiterkörper mit Kontaktschichten des gleichen Leitungstyps bietet den Vorteil, dass Anschlussschichten Anwendung finden können, die für den Leitungstyp der Kontaktschichten besonders geeignet sind. Eine Anschlussschicht kann in Abhängigkeit vom Leitungstyp der Kontaktschichten - n-leitend oder p-leitend - unterschiedliche elektrische Kontakteigenschaften zu der Kontaktschicht aufweisen. Insbesondere können unterschiedliche Kontakteigenschaften zu einer vorgegebenen Anschlussschicht auch bei bis auf die Dotierung gleich zusammengesetzten Kontaktschichten auftreten. Da die Leitungstypen der Kontaktschichten vorliegend gleich ausgebildet sind, kann mittels der Anschlussschichten zu beiden Kontaktschichten vereinfacht ein elektrischer Kontakt ausgebildet werden, dessen Kontakteigenschaften zu der jeweiligen Anschlussschicht nicht aufgrund unterschiedlicher Leitungstypen beeinflusst werden.

Da die Anschlussschichten strahlungsdurchlässig für die im aktiven Bereich erzeugte Strahlung ausgebildet sind, können Absorptionsverluste in den Anschlussschichten beim Strahlungsdurchtritt durch diese Schichten vermindert oder im wesentlichen vollständig vermieden werden. Die auf die dem Halbleiterkörper abgewandte Seite der Anschlussschichten hindurch tretende Strahlungsleistung kann so erhöht werden.

Bevorzugt enthalten die Anschlussschichten ein strahlungsdurchlässiges Material oder eine strahlungsdurchlässige Materialzusammensetzung oder bestehen aus einem derartigen Material beziehungsweise einer derartigen Materialzusammensetzung.

In einer bevorzugten Ausgestaltung enthalten die Anschlussschichten ein strahlungsdurchlässiges und elektrisch leitfähiges Oxid, insbesondere ein Metalloxid, (TCO: Transparent Conductive Oxide). TCO-Materialien zeichnen sich durch hohe Strahlungsdurchlässigkeit bei gleichzeitig großer elektrischer Leitfähigkeit, insbesondere in lateraler Richtung, aus. Ein TCO-Material'ist für eine Anschlussschicht für einen.strahlungsemittierenden Halbleiterkörper, zum Beispiel einen Halbleiterkörper für eine Lumineszenzdiode, besonders geeignet. Geeignete TCO-Materialien sind zum Beispiel ein Zinnoxid, wie SnO oder SnO₂, ein Zinkoxid, wie ZnO, ein Indiumzinnoxid (ITO: Indium Tin Oxide) oder ein Titanoxid, wie TiO₂.

Zur Erhöhung der Leitfähigkeit kann eine TCO-haltige Anschlussschicht dotiert sein. Insbesondere können beide Anschlussschichten dotiert sein. Für ZnO eignet sich für die Dotierung zum Beispiel Al.

In einer weiteren bevorzugten Ausgestaltung enthalten die Anschlussschichten gleiche Materialien, insbesondere das gleiche TCO-Material, zum Beispiel Zinkoxid. Besonders bevorzugt sind die Anschlussschichten gleich zusammengesetzt. Dies hat den Vorteil, dass für die Kontaktbildung zu Halbleitermaterialien ein besonders geeignetes Material für die Anschlussschicht, wie etwa ein Zinkoxid, eingesetzt werden kann. Insbesondere kann ein Material eingesetzt werden, bei dem das Ausbilden eines elektrischen Kontakts mit gleichartigen Kontakteigenschaften zu Halbleitermaterialien beider Leitungstypen - p-leitend wie n-leitend - nicht oder nur stark erschwert möglich ist.

Bevorzugt weisen die Kontaktschichten die gleiche Dotierstoffkonzentration auf.

In einer weiteren bevorzugten Ausgestaltung sind die Kontaktschichten p-leitend ausgeführt. P-leitende Kontaktschichten sind zur Kontaktbildung zu TCO-Materialien, insbesondere zu Zinkoxid, etwa n-leitendem Zinkoxid, besonders geeignet. Es hat sich herausgestellt, dass der elektrische Kontakt mittels eines TCO-Materials zu einer p-leitenden Schicht gegenüber dem elektrischen Kontakt zu einer n-leitenden Schicht vereinfacht mit guten Kontakteigenschaften, zum Beispiel mit geringerem Spannungsabfall, hergestellt werden kann.

In einer weiteren bevorzugten Ausgestaltung grenzt eine Anschlussschicht an die zugeordnete Kontaktschicht an. Bevorzugt grenzt die eine Anschlussschicht an die eine Kontaktschicht und die andere Anschlussschicht an die andere Kontaktschicht an. Die jeweilige Anschlussschicht grenzt vorzugsweise vollflächig an den Halbleiterkörper an. Auf eine Zwischenschicht, zum Beispiel eine semitransparente Metallschicht, zur Verbesserung der elektrischen Kontakteigenschaften zwischen einer Anschlussschicht und der zugeordneten Kontaktschicht, kann verzichtet werden. Vielmehr kann bereits mittels der Kontaktschichten vom gleichen Leitungstyp beidseitig gut elektrisch kontaktierbares Halbleitermaterial des Halbleiterkörpers angeboten werden. Die Absorption von Strahlung in einer Metall-Zwischenschicht kann so vermieden werden.

In einer weiteren vorteilhaften Ausgestaltung ist zwischen einer der Anschlussschichten, insbesondere genau einer der Anschlussschichten, und dem aktiven Bereich ein Tunnelübergang angeordnet. Der Tunnelübergang ist bevorzugt in der Halbleiterschichtenfolge integriert und umfasst besonders bevorzugt zwei, vorzugsweise hochdotierte, Tunnelschichten unterschiedlichen Leitungstyps.

Hierbei kann eine von dem aktiven Bereich abgewandte Tunnelschicht des Tunnelübergangs als eine der Kontaktschichten ausgebildet sein oder der Tunnelübergang kann zwischen einer der Kontaktschichten und dem aktiven Bereich angeordnet sein. Im ersteren Falle kann auf eine zusätzliche Kontaktschicht im Halbleiterkörper verzichtet werden. Im letzteren Fall können der Tunnelübergang und die Kontaktschicht dagegen unabhängig voneinander ausgebildet werden.

Die vom aktiven Bereich abgewandte Tunnelschicht und die Kontaktschichten weisen vorzugsweise den gleichen Leitungstyp auf. Die dem aktiven Bereich zugewandte Tunnelschicht weist einen Leitungstyp auf, der von dem der Kontaktschichten verschieden ist.

Über den Tunnelübergang kann die Kontaktschicht elektrisch leitend mit vorteilhaft geringem Widerstand mit einer auf der der Kontaktschicht gegenüberliegenden Seite des Tunnelübergangs angeordneten Halbleiterschicht der Halbleiterschichtenfolge, die einen vom Leitungstyp der Kontaktschicht verschiedenen Leitungstyp aufweist, elektrisch leitend verbunden werden.

Trotz der beiden Kontaktschichten mit dem gleichen Leitungstyp kann der Halbleiterkörper ab der dem aktiven Bereich zugewandten Seite des Tunnelübergangs mit dem Leitungstypverlauf eines herkömmlichen Lumineszenzdioden-Halbleiterkörpers, also p-leitend/aktiver Bereich/n-leitend bzw. n-leitend/aktiver Bereich/p-leitend, ausgebildet werden.

Der Tunnelübergang ist vorzugsweise im direkten Strompfad zwischen einer den Halbleiterkörper begrenzenden Oberfläche, die zweckmäßigerweise durch eine der Kontaktschichten gebildet ist, und dem dieser Oberfläche nächstliegenden aktiven Bereich des Halbleiterkörpers angeordnet. Im Gegensatz zu einem Halbleiterkörper mit einer Mehrzahl von aktiven Bereichen, bei dem ein Tunnelübergang zwischen zwei aktiven Bereichen angeordnet ist, dient der Tunnelübergang vorliegend der elektrisch leitenden Verbindung der Kontaktschicht zum aktiven Bereich und nicht der elektrischen Ankopplung verschiedener aktiver Bereiche aneinander. Der Halbleiterkörper kann insbesondere genau einen aktiven Bereich umfassen.

In einer weiteren bevorzugten Ausgestaltung weist die dem aktiven Bereich zugewandte Tunnelschicht den gleichen Leitungstyp auf wie eine zwischen dem aktiven Bereich und dem Tunnelübergang angeordnete Halbleiterschicht der Halbleiterschichtenfolge, zum Beispiel eine Mantelschicht der Halbleiterschichtenfolge. Der Leitungstyp dieser Halbleiterschicht ist vom Leitungstyp der Kontaktschichten zweckmäßigerweise verschieden.

In einer weiteren bevorzugten Ausgestaltung ist auf der dem Halbleiterkörper abgewandten Seite einer der Anschlussschichten, insbesondere genau einer der Anschlussschichten, eine Spiegelschicht angeordnet. Mittels der Spiegelschicht kann im aktiven Bereich erzeugte und durch diese.Anschlussschicht hindurch tretende Strahlung reflektiert werden. Die von der Spiegelschicht reflektierte Strahlung kann wieder in den Halbleiterkörper eintreten.

Mittels der Spiegelschicht kann demnach die über die der Spiegelschicht abgewandte Seite des Halbleiterkörpers aus dem Halbleiterkörper austretende Strahlungsleistung erhöht werden. Ferner kann einer Absorption von Strahlung in auf der vom aktiven Bereich abgewandten Seite der Spiegelschicht angeordneten Elementen vorgebeugt werden.

Der Tunnelübergang kann zwischen der Spiegelschicht und dem aktiven Bereich oder auf der von der Spiegelschicht abgewandten Seite des aktiven Bereichs angeordnet sein.

Die Spiegelschicht enthält bevorzugt ein Metall. Besonders bevorzugt ist die Spiegelschicht metallisch, insbesondere als Metallisierung, oder als metallhaltige Legierung ausgebildet. Die Legierung hat bevorzugt metallischen Charakter. Beispielsweise enthält die Spiegelschicht Au, Al oder Ag oder eine Legierung mit mindestens einem dieser Metalle, wie AuGe.

Die Spiegelschicht ist vorzugsweise auf die Anschlussschicht aufgebracht, insbesondere auf der Anschlussschicht abgeschieden.

Bevorzugt ist die Spiegelschicht elektrisch leitend ausgeführt und besonders bevorzugt elektrisch leitend mit dem aktiven Bereich verbunden. Die Spiegelschicht kann demnach der elektrischen Kontaktierung des aktiven Bereichs dienen.

In einer weiteren bevorzugten Ausgestaltung enthält der Halbleiterkörper ein III-V-Halbleitermaterial. Insbesondere kann der aktive Bereich, die Tunnelschicht(en), Kontaktschicht(en) und/oder die zwischen dem Tunnelübergang und dem aktiven Bereich angeordnete Halbleiterschicht ein III-V-Halbleitermaterial enthalten. III-V-Halbleitermaterialien zeichnen sich durch hohe interne Quanteneffizienz bei der Strahlungserzeugung aus.

Vorzugsweise enthält der aktive Bereich ein Material aus dem Materialsystem Inₓ Ga_{y} Al_{1-x-y} P, mit 0≤x≤1, 0≤y≤1 und x+y≤1. Dabei kann y≠0, y≠1, x≠0 und/oder x≠1 sein. Dieses Materialsystem ist zur Erzeugung von Strahlung vom gelben bis in den roten Spektralbereich besonders geeignet.

Mit Vorzug basieren die Kontaktschichten auf dem gleichen Halbleitermaterialsystem, insbesondere einem III-V-Halbleitermaterialsystem.

Zur elektrischen Kontaktbildung zu einem Zinkoxid ist eine Kontaktschicht, die ein Material aus dem Materialsystem Al_{y} Ga_{1-y} As mit 0≤y≤1, gegebenenfalls mit y≠0 enthält, insbesondere eine GaAs oder AlGaAs enthaltende oder daraus bestehende Kontaktschicht, besonders geeignet. Beispielsweise enthält eine der Kontaktschichten, vorzugsweise enthalten beide Kontaktschichten GaAs oder AlGaAs.

Die Kontaktschichten können bezüglich des verwendeten Halbleitermaterials und/oder des eingesetzten Dotierstoffs, gegebenenfalls einschließlich der Dotierstoffkonzentration, die gleiche Zusammensetzung aufweisen.

Mit Vorzug basieren die Tunnelschichten auf dem gleichen Halbleitermaterialsystem, insbesondere einem III-V-Halbleitermaterialsystem. Die Tunnelschichten können ein Material aus dem Materialsystem Al_{y} Ga_{1-y} As mit 0≤y≤1, gegebenenfalls mit y≠0, enthalten.

Vorzugsweise ist die auf der von der Spiegelschicht abgewandten Seite des Halbleiterkörpers angeordnete Anschlussschicht als Stromaufweitungsschicht ausgebildet. Über einen auf der von der Spiegelschicht abgewandten Seite des Halbleiterkörpers angeordneten elektrischen Anschluss, der mit der Stromaufweitungsschicht elektrisch leitend verbunden ist, in die Stromaufweitungsschicht gelangender Strom kann in der Stromaufweitungsschicht lateral verteilt werden und großflächig in den Halbleiterkörper gelangen. Bei einer strahlungsdurchlässigen Anschlussschicht kann auf großflächige Anschlussstrukturen, etwa großflächige Anschlussmetallisierungen, zur homogenen Stromeinprägung verzichtet werden.

Die zwischen dem Halbleiterkörper und der Spiegelschicht angeordnete Anschlussschicht ist zweckmäßigerweise zur elektrischen Kontaktbildung zum Halbleiterkörper ausgebildet. Da die Spiegelschicht mit Vorzug großflächig vorgesehen ist und elektrisch leitfähig ausgebildet ist, ist eine Ausbildung dieser Anschlussschicht als Stromaufweitungsschicht nicht erforderlich. Da die elektrische Kontaktbildung zum Halbleiterkörper mittels der Anschlussschicht erfolgt, kann die Spiegelschicht hinsichtlich hoher Reflektivität optimiert ausgeführt werden.

Die Anschlussschichten können unterschiedliche Dicken aufweisen. Eine zur Stromaufweitung ausgebildete Anschlussschicht - etwa die auf der der Spiegelschicht abgewandten Seite des Halbleiterkörpers angeordnete Anschlussschicht - ist vorzugsweise dicker ausgebildet als eine hauptsächlich der elektrischen Kontaktbildung dienende Anschlussschicht.

In einer weiteren bevorzugten Ausgestaltung ist der Halbleiterkörper als Dünnfilm-Halbleiterkörper ausgeführt. Bei einem Dünnfilm-Halbleiterkörper ist das Herstellungssubstrat, auf dem die Halbleiterschichtenfolge für den Halbleiterkörper hergestellt, insbesondere abgeschieden wurde, bereichsweise oder vollständig entfernt. Das Herstellungssubstrat ist vorzugsweise das Aufwachssubstrat, auf dem die Halbleiterschichtenfolge epitaktisch gewachsen ist. Das Herstellungssubstrat ist vorzugsweise derart entfernt, dass die dem Herstellungssubstrat zugewandte Oberfläche des Halbleiterkörpers einer weiteren Prozessierung zugänglich ist.

Da das Herstellungssubstrat entfernt ist, können mit Vorteil beidseitig - sowohl auf der dem Herstellungssubstrat zugewandten Seite als auch auf der dem Herstellungssubstrat abgewandten Seite des Halbleiterkörpers - Anschlussschichten auf den vorgefertigten Halbleiterkörper aufgebracht werden.

Für die Herstellung des Dünnfilm-Halbleiterkörpers wird zum Beispiel zunächst eine Halbleiterschichtenfolge für den Dünnfilm-Halbleiterkörper mit einem zur Strahlungserzeugung geeigneten aktiven Bereich und zwei Kontaktschichten vom gleichen Leitungstyp, die auf einem Substrat, vorzugsweise dem Aufwachssubstrat der Halbleiterschichtenfolge angeordnet ist, bereitgestellt. Nachfolgend wird auf die dem Substrat abgewandte Seite eine strahlungsdurchlässige und elektrisch leitfähige Anschlussschicht auf den Halbleiterkörper aufgebracht, wobei diese Anschlussschicht mit einer der Kontaktschichten elektrisch leitend verbunden ist.

Daraufhin wird das Substrat entfernt und eine weitere strahlungsdurchlässige und elektrisch leitfähige Anschlussschicht auf die freigelegte Oberfläche des Halbleiterkörpers aufgebracht, wobei diese Anschlussschicht mit der anderen Kontaktschicht elektrisch leitend verbunden ist.

Ein erfindungsgemäßer Halbleiterchip umfasst einen erfindungsgemäßen Halbleiterkörper und einen Träger, auf dem der Halbleiterkörper angeordnet ist. Vorzugsweise ist der Halbleiterkörper mit dem Träger verbunden. Hierzu kann zwischen dem Halbleiterkörper und dem Träger, insbesondere zwischen der Spiegelschicht und dem Träger, eine Verbindungsschicht ausgebildet sein. Die Verbindungsschicht ist bevorzugt elektrisch leitfähig ausgebildet und besonders bevorzugt elektrisch leitend mit dem aktiven Bereich verbunden.

Der Träger stabilisiert den Halbleiterkörper mit Vorzug mechanisch. Die Gefahr einer Schädigung des Halbleiterkörpers - auch bei entferntem Aufwachssubstrat - kann so verringert werden. Der Halbleiterkörper wird bevorzugt auf dem Träger angeordnet bevor das Substrat für die Ausbildung eines Dünnfilm-Halbleiterkörpers entfernt wird. Der Träger ist von dem Herstellungssubstrat, insbesondere dem Aufwachssubstrat der Halbleiterschichtenfolge verschieden.

Ein Dünnfilm-Halbleiterchip, das heißt ein Chip mit einem Dünnfilm-Halbleiterkörper, der auf einem Träger angeordnet ist, der vom Herstellungssubstrat der Halbleiterschichtenfolge verschieden ist, kann sich weiterhin durch eines oder eine Mehrzahl der folgenden Merkmale auszeichnen:
- an einer zu dem Träger hin gewandten ersten Hauptfläche einer strahlungserzeugenden Epitaxieschichtenfolge ist eine reflektierende Schicht aufgebracht oder ausgebildet, die zumindest einen Teil der in der Epitaxieschichtenfolge erzeugten elektromagnetischen Strahlung in diese zurückreflektiert;
- die Epitaxieschichtenfolge weist eine Dicke im Bereich von 20µm oder weniger, insbesondere im Bereich von 10 µm auf; und/oder
- die Epitaxieschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der epitaktischen Epitaxieschichtenfolge führt, das heißt sie weist ein möglichst ergodisch stochastisches Streuverhalten auf.

Ein Grundprinzip eines Dünnschicht-Leuchtdiodenchips ist beispielsweise in I. Schnitzer et al., Appl. Phys. Lett. 63 (16), 18. Oktober 1993, 2174 - 2176 beschrieben, deren Offenbarungsgehalt insofern hiermit durch Rückbezug aufgenommen wird.

Ein Dünnfilm-Leuchtdioden-Chip ist in guter Näherung ein Lambertscher Oberflächenstrahler und eignet sich von daher besonders gut für die Anwendung in einem Scheinwerfer.

Weitere Merkmale, Vorteile und Zweckmäßigkeiten der Erfindung ergeben sich aus der folgenden Beschreibung der Ausführungsbeispiele in Verbindung mit den Figuren.
- Figur 1: zeigt drei Ausführungsbeispiele eines erfindungsgemäßen Halbleiterchips anhand der in den Figuren 1A, 1B und 1C dargestellten schematischen Schnittansichten.
- Figur 2: zeigt drei weitere Ausführungsbeispiele von erfindungsgemäßen Halbleiterchips anhand der in den Figuren 2A, 2B und 2C dargestellten schematischen Schnittansichten.
- Figur 3: zeigt ein Ausführungsbeispiel eines erfindungsgemäßen Halbleiterchips anhand einer schematischen Schnittansicht.
- Figur 4: zeigt zwei weitere Ausführungsbeispiele von erfindungsgemäßen Halbleiterchips anhand der in den Figuren 4A und 4B schematisch dargestellten Schnittansichten.
- Figur 5: zeigt ein weiteres Ausführungsbeispiel eines erfindungsgemäßen Halbleiterchips anhand einer schematischen Schnittansicht.
- Figur 6: zeigt ein weiteres Ausführungsbeispiel eines erfindungsgemäßen Halbleiterchips anhand einer schematischen Schnittansicht.
- Figur 7: zeigt ein weiteres Ausführungsbeispiel eines erfindungsgemäßen Halbleiterchips anhand einer schematischen Aufsicht.

Gleiche, gleichartige und gleich wirkende Elemente sind in den Figuren mit gleichen Bezugszeichen versehen. Weiterhin sind die Figuren, insbesondere hinsichtlich der Abmessungen der Einzelelemente relativ zueinander, nicht notwendigerweise maßstabsgetreu ausgeführt. Einzelelemente können in den Figuren vielmehr zum besseren Verständnis übertrieben groß dargestellt sein.

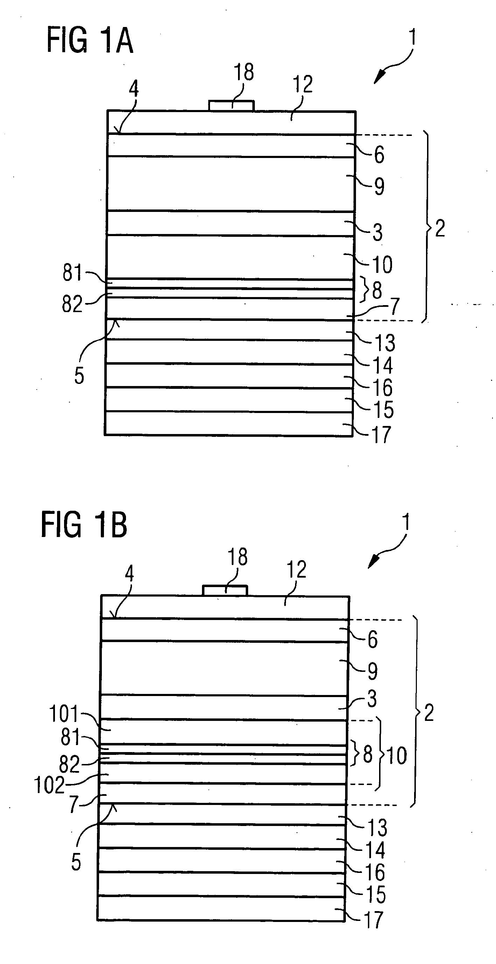

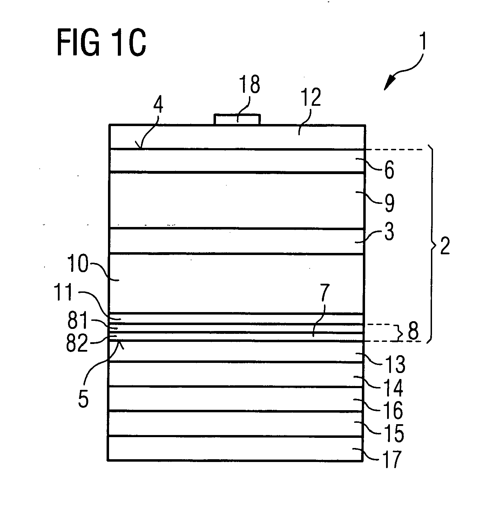

Figur 1 zeigt drei Ausführungsbeispiele eines erfindungsgemäßen Halbleiterchips anhand der in den Figuren 1A, 1B beziehungsweise 1C dargestellten schematischen Schnittansichten.

Der Halbleiterchip 1 umfasst jeweils einen Halbleiterkörper 2. Der Halbleiterkörper 2 umfasst eine Halbleiterschichtenfolge mit einem zur Strahlungserzeugung geeigneten aktiven Bereich 3. Die Halbleiterschichtenfolge umfasst eine Mehrzahl von Halbleiterschichten. Insbesondere ist der Halbleiterkörper 2 vorzugsweise durch die Halbleiterschichtenfolge gebildet.

Der Halbleiterkörper 2 ist weiterhin als Lumineszenzdioden-Halbleiterkörper zur Strahlungserzeugung, vorzugsweise als LED-Halbleiterkörper zur Erzeugung inkohärenter Strahlung, ausgebildet.

Weiterhin weist der Halbleiterkörper 2 eine Oberseite 4 und eine Unterseite 5 auf. Die Oberseite 4 ist vorzugsweise zur Strahlungsauskopplung von in dem aktiven Bereich erzeugter Strahlung aus dem Halbleiterkörper 2 ausgebildet (Auskoppelseite). Die Unterseite 5 dient vorzugsweise als Montageseite, seitens derer der Halbleiterkörper 2 auf einem Trägerelement, beispielsweise direkt auf einen Anschlussträger, etwa eine, vorzugsweise gedruckte, Leiterplatte, montiert wird (nicht explizit dargestellt).

Die Halbleiterschichtenfolge umfasst weiterhin eine erste Kontaktschicht 6 und eine zweite Kontaktschicht 7. Der aktive Bereich 3 ist zwischen den Kontaktschichten 6, 7 angeordnet. Die Kontaktschichten 6, 7 sind für den gleichen Leitungstypen - p-leitend oder n-leitend - dotiert. Die Kontaktschichten 6, 7 sind bevorzugt für die externe elektrische Kontaktbildung zum Halbleiterkörper ausgebildet. Zweckmäßigerweise begrenzen die Kontaktschichten 6, 7 den Halbleiterkörper 2 seitens der Ober- beziehungsweise der Unterseite.

Weiterhin ist in der Halbleiterschichtenfolge ein Tunnelübergang 8 monolithisch integriert. Der Tunnelübergang 8 umfasst eine erste Tunnelschicht 81 und eine zweite Tunnelschicht 82. Die Tunnelschichten 81 und 82 sind für unterschiedliche Leitungstypen dotiert. Ferner ist der Tunnelübergang 8 zwischen der Unterseite 5 des Halbleiterkörpers 2 und dem aktiven Bereich 3 im Halbleiterkörper angeordnet. Die vom aktiven Bereich 3 abgewandte zweite Tunnelschicht 82 weist bevorzugt den gleichen Leitungstypen wie die Kontaktschichten 6, 7 auf.

Die Halbleiterschichtenfolge umfasst weiterhin eine erste Mantelschicht 9 oder eine entsprechende Mantelschichtenfolge und eine zweite Mantelschicht 10 oder eine entsprechende Mantelschichtenfolge. Der aktive Bereich ist zwischen der ersten Mantelschicht 9 und der zweiten Mantelschicht 10 angeordnet. Die erste Mantelschicht 9 ist weiterhin zwischen der ersten Kontaktschicht 6 und dem aktiven Bereich 3 angeordnet. Die Mantelschicht 10 ist zwischen der zweiten Kontaktschicht 7 und dem aktiven Bereich 3 angeordnet. Die Mantelschichten 9 und 10 sind für unterschiedliche Leitungstypen dotiert. Die auf der dem Tunnelübergang 8 abgewandten Seite des aktiven Bereichs angeordnete Mantelschicht 9 weist vorzugsweise den gleichen Leitungstypen wie die Kontaktschichten 6, 7 auf.

Unterschiede zwischen den in den Figuren 1A, 1B und 1C dargestellten Halbleiterkörpern 2 sind in der Anordnung des Tunnelübergangs 8 im jeweiligen Halbleiterkörper gegeben.

Im Ausführungsbeispiel gemäß Figur 1A ist der Tunnelübergang 8 zwischen der zweiten Kontaktschicht 7 und dem aktiven Bereich und insbesondere zwischen der zweiten Kontaktschicht 7 und der zweiten Mantelschicht 10 angeordnet.

Im Ausführungsbeispiel gemäß Figur 1B ist der Tunnelübergang 8 in die Mantelschichtenfolge 10 integriert und damit gegenüber Figur 1A näher am aktiven Bereich angeordnet. Die Mantelschichtenfolge weist hierbei zwei Mantelschichten 101, 102 auf, zwischen denen der Tunnelübergang angeordnet ist.

In den Halbleiterkörpern 2 gemäß den Figuren 1A und 1B ist demnach jeweils eine gesonderte, vom Tunnelübergang getrennte zweite Kontaktschicht 7 vorgesehen.

Im Gegensatz hierzu ist die von dem aktiven Bereich 3 abgewandte zweite Tunnelschicht 82 des Tunnelübergangs im Ausführungsbeispiel gemäß Figur 1C als zweite Kontaktschicht 7 ausgebildet. Zwischen dem Tunnelübergang und der Mantelschicht 10 kann eine Halbleiterschicht 11 angeordnet sein.

Zwischen dem Tunnelübergang 8 und der Unterseite 5 angeordnete Schichten der Halbleiterschichtenfolge sind bevorzugt für den gleichen Leitungstypen wie die Kontaktschichten 6 und 7 dotiert (vergleiche zum Beispiel die Mantelschicht 102 in Figur 1B). Zwischen dem Tunnelübergang 8 und dem aktiven Bereich 3 angeordnete Schichten der Halbleiterschichtenfolge sind vorzugsweise für den von den Kontaktschichten entgegengesetzten Leitungstypen dotiert (vergleiche die Mantelschichten 10 in den Figuren 1A und 1C, die Mantelschicht 101 in Figur 1B und die Halbleiterschicht 11 in Figur 1C).

Die Mantelschichtenfolge 10 kann insbesondere zusätzlich zum Tunnelübergang 8 zwei Halbleiterschichten unterschiedlichen Leitungstyps aufweisen (vgl. die Mantelschichten 101 und 102 gemäß Figur 1B).

Über den Tunnelübergang 8 kann erreicht werden, dass trotz der beiden Kontaktschichten vom gleichen Leitungstyp eine vergleichsweise, also gegenüber dem Verzicht auf den Tunnelübergang, widerstandsarme elektrische Ankopplung der Unterseite 5 des Halbleiterkörpers an den aktiven Bereich 3 erzielt wird. Wird auf einen Tunnelübergang verzichtet, so kann sich ein maßgeblich sperrender pn-Übergang zwischen der Unterseite und dem aktiven Bereich ausbilden. Eine Zuführung von Ladungsträgern zum aktiven Bereich zur strahlenden Rekombination würde so erheblich gehemmt und die Effizienz des Halbleiterkörpers würde in der Folge gemindert.

Würden beispielsweise die Kontaktschicht 7 und die Mantelschicht 10 in Figur 1A aneinander grenzen, so würde sich ein derartiger maßgeblich sperrender pn-Übergang ausbilden.

Über den Tunnelübergang 8 kann eine widerstandsarme Ladungsträgerzufuhr zum aktiven Bereich 3 trotz der zwischen dem aktiven Bereich und der Unterseite 5 angeordneten Schichten unterschiedlichen Leitungstyps - der Mantelschicht 10 beziehungsweise 101 und der zweiten Kontaktschicht 7 - realisiert werden.

Weiterhin sind die Tunnelschichten 81 und 82 vorzugsweise hoch dotiert, bevorzugt mit einer Dotierstoffkonzentration von 1*10¹⁸ 1/cm³ oder mehr, besonders bevorzugt von 1*10¹⁹ 1/cm³ oder mehr, am meisten bevorzugt von 1*10²⁰ 1/cm³ oder mehr, ausgebildet.

Die Tunnelschichten 81 und 82 weisen bevorzugt eine höhere Dotierstoffkonzentration auf als eine im Halbleiterkörper an die jeweilige Tunnelschicht gegebenenfalls angrenzende Schicht vom gleichen Leitungstyp.

Eine Dicke der jeweiligen Tunnelschicht beträgt bevorzugt 20 nm oder weniger, besonders bevorzugt 10 nm oder weniger.

Der Halbleiterkörper 2 ist zwischen einer ersten Anschlussschicht 12 und einer zweiten Anschlussschicht 13 angeordnet. Diese Anschlussschichten sind mit Vorzug auf die Oberseite 4 (Anschlussschicht 12) beziehungsweise die Unterseite 5 des Halbleiterkörpers 2 (Anschlussschicht 13) aufgebracht. Der Halbleiterkörper 2 ist vor dem Aufbringen der Anschlussschichten bereits vorgefertigt.

Weiterhin grenzen die Anschlussschichten 12 und 13 vorzugsweise unmittelbar an den Halbleiterkörper 2 an. Die Anschlussschichten 12 und 13 sind aus einem für die im aktiven Bereich 3 erzeugte Strahlung durchlässigen Material oder einer entsprechenden Materialzusammensetzung ausgebildet. Besonders geeignet sind TCO-Anschlussschichten, beispielsweise aus Zinkoxid, Zinnoxid, Indiumzinnoxid oder Titanoxid (vergleiche die Beschreibung weiter oben). Zur Erhöhung der Leitfähigkeit kann die Anschlussschicht geeignet dotiert sein. Für ZnO eignet sich beispielsweise Al.

Da beide Kontaktschichten 6, 7 den gleichen Leitungstypen aufweisen, kann ein Leitungstyp gewählt werden, welcher für die Kontaktbildung zu TCO-Materialien besonders geeignet ist. Insbesondere kann für beide Anschlussschichten 12 und 13 das gleiche TCO-Material eingesetzt werden. Die Kontakteigenschaften eines TCO-Materials zu dem Halbleitermaterial des Halbleiterkörpers hängen oftmals vom Leitungstypen des Halbleitermaterials ab.

Über eine metallische Zwischenschicht zwischen dem TCO-Material und dem Halbleiterkörper kann zwar gegebenenfalls ein guter elektrischer Kontakt auch zu einem Halbleitermaterial vom weniger geeigneten Leitungstyp hergestellt werden. In der metallischen Zwischenschicht würde im aktiven Bereich erzeugte Strahlung jedoch absorbiert werden und in der Folge die Effizienz der Strahlungsauskopplung aus dem Chip mindern. Da beim Halbleiterkörper 2 zwei Schichten gleichen Leitungstyps für die Kontaktbildung zum Halbleiterkörper zur Verfügung stehen, kann auf eine Zwischenschicht verzichtet werden.

Zinkoxid beispielsweise zeichnet sich durch besonders gute elektrische Kontakteigenschaften zu p-leitendem Halbleitermaterial, insbesondere p-dotiertem GaAs oder p-dotiertem AlGaAs aus. Als Zinkoxid wird vorzugsweise ein n-leitendes Zinkoxid eingesetzt. Zwischen einer p-leitenden Kontaktschicht und n-leitendem Zinkoxid bildet sich zwar ein Tunnelkontakt aus, dieser erzeugt aber nur einen geringen Spannungsabfall und mindert die Effizienz des Halbleiterchips nicht maßgeblich.

Der elektrische Kontakt zwischen der Anschlussschicht und der Kontaktschicht kann eine im Wesentlichen ohmsche Strom-Spannungs-Charakteristik aufweisen.

Bevorzugt enthalten oder bestehen die Kontaktschichten 6 und 7 aus p-GaAs oder p-AlGaAs. Für eine AlGaAs-haltige Kontaktschicht eignet sich besonders ein Al-Gehalt von 0,6 oder weniger, bevorzugt von 0,5 oder weniger, besonders bevorzugt von 0,3 oder weniger.

Der aktive Bereich 3 ist vorzugsweise zur Erzeugung sichtbarer Strahlung ausgebildet. Beispielsweise enthält der aktive Bereich InGaAlP. Dieses III-V-Halbleitermaterial.ist zur Erzeugung von Strahlung vom gelben bis in den roten Spektralbereich besonders geeignet.

Die Tunnelschichten 81 und 82 enthalten vorzugsweise GaAs oder AlGaAs oder bestehen hieraus.

Die Mantelschichten 10, 101, 102 basieren bevorzugt auf Inₓ Ga_{y} Al_{1-x-y} P.

Auf (Al)GaAs-basierende Halbleiterschichten und Halbleiterschichten auf der Basis von Inₓ Ga_{y} Al_{1-x-y} P können epitaktisch aufeinander gewachsen werden.

In einer bevorzugten Ausgestaltung sind die Kontaktschichten 6 und 7 hoch dotiert ausgeführt. Hierzu weisen die Kontaktschichten 6 und 7 zweckmäßigerweise eine höhere Dotierstoffkonzentration auf als eine Schicht im Halbleiterkörper vom gleichen Leitungstyp. Bevorzugt ist eine Dotierstoffkonzentration der Kontaktschichten 1*10¹⁸ 1/cm³ oder größer, 1*10¹⁹ 1/cm³ oder größer, am meisten bevorzugt 1*10²⁰ 1/cm³ oder größer.

Derartige Dotierstoffkonzentrationen sind für die Kontaktbildung zu einem TCO-Material, insbesondere für Kontaktschichten auf (Al)GaAs-Basis hinsichtlich der Ausbildung eines guten elektrischen Kontakts zu ZnO, gegebenenfalls zu ZnO:Al, besonders geeignet.

Als Dotierstoff ist für die Schichten des Halbleiterkörpers 2 für eine p-leitende Dotierung zum Beispiel Mg oder C als Akzeptor, für eine n-leitende Dotierung zum Beispiel Si als Donator geeignet. Für hohe Dotierstoffkonzentrationen eignet sich C, insbesonders für Halbleitermaterialien auf GaAs-Basis, wie z.B. auf (Al)GaAs-basierende Materialien, besonders. Die Tunnelschicht(en) und/oder die Kontaktschicht(en) sind bevorzugt mit C dotiert.

In einer weiteren bevorzugten Ausgestaltung weisen die Kontaktschichten 6 und 7 die gleiche Zusammensetzung auf, vorzugsweise einschließlich der Dotierung, also des verwendeten Dotierstoffs und/oder der Dotierstoffkonzentration. Hierüber kann vereinfacht beidseitig ein gleichartiger elektrischer Kontakt zum Halbleiterkörper ausgebildet werden.

Die erste Kontaktschicht und/oder die zweite Kontaktschicht weist bevorzugt eine Dicke von 100 nm oder weniger, besonders bevorzugt von 50 nm oder weniger, insbesondere von 20 nm oder weniger auf. Derart geringe Dicken können zur elektrischen Kontaktbildung zu den Anschlussschichten bereits ausreichen. Die beiden Kontaktschichten können die gleiche Dicke aufweisen.

Auf der dem Halbleiterkörper 2 abgewandten Seite der zweiten Anschlussschicht 13 ist eine Spiegelschicht 14 angeordnet. Die.Spiegelschicht 14 grenzt vorzugsweise unmittelbar an die zweite Anschlussschicht 13 an.

Beispielsweise enthält die Spiegelschicht 14 ein Metall, insbesondere Au, oder besteht aus einem Metall. Auch eine Spiegelschicht, die eine Legierung, zum Beispiel AuGe, enthält, kann eingesetzt werden. Diese Materialien zeichnen sich für im Materialsystem Inₓ Ga_{y} Al_{1-x-y} P erzeugbare Strahlung durch besonders hohe Reflektivitäten aus.

Spiegelschichten mit Metallcharakter zeichnen sich weiterhin durch vorteilhaft geringe Abhängigkeit der Reflektivität vom Einfallswinkel der Strahlung aus.

Mittels der Spiegelschicht 14 kann im aktiven Bereich 3 erzeugte und nach dem Durchtritt durch die zweite Anschlussschicht 13 auf die Spiegelschicht treffende Strahlung in die Halbleiterschichtenfolge zurückreflektiert werden und über die dem Halbleiterkörper abgewandte Seite der ersten Anschlussschicht 12 austreten. Die auskoppelseitige austretende Strahlungsleistung wird somit vorteilhaft erhöht. Weiterhin kann mittels der Spiegelschicht der Absorption von Strahlung in auf der vom aktiven Bereich 3 abgewandten Seite der Spiegelschicht angeordneten Strukturen vorgebeugt werden.

Der Halbleiterkörper 2 ist weiterhin als Dünnfilm-Halbleiterkörper ausgeführt. Der Halbleiterkörper 2 ist hierzu epitaktisch auf einem Aufwachssubstrat, zum Beispiel mittels MOVPE, gewachsen. Für die oben genannten Halbleitermaterialsysteme eignet sich zum Beispiel GaAs als Aufwachssubstrat.

Für den Dünnfilm-Halbleiterkörper ist das Aufwachssubstrat vom Halbleiterkörper nach dem Aufwachsprozess entfernt und daher in den Figuren nicht dargestellt. Das Aufwachssubstrat kann mittels Ätzen oder Lasertrennen entfernt werden. Aufgrund des entfernten Aufwachssubstrats können nach der Epitaxie des Halbleiterkörpers beidseitig TCO-Anschlussschichten auf dem Halbleiterkörper 2 abgeschieden werden. Für das Abscheiden der Anschlussschichten 12, 13 wird mit Vorzug ein vom Herstellungsprozess des Halbleiterkörpers 2 verschiedenes Verfahren, insbesondere kein Epitaxie-Verfahren, eingesetzt. Für das Abscheiden der Anschlussschichten eignen sich beispielsweise ein PVD-Verfahren (PVD: Physical Vapor Deposition), wie Sputtern oder Aufdampfen, oder ein CVD-Verfahren, wie PECVD (PECVD: Plasma Enhanced Chemical Vapor Deposition).

Für den Dünnfilm-Halbleiterchip 1 ist der Halbleiterkörper 2 auf einem Träger 15 befestigt. Dieser ist von dem Aufwachssubstrat der Halbleiterschichtenfolge verschieden. Beispielsweise enthält der Träger GaAs oder Ge oder besteht hieraus.

Die Spiegelschicht 14 kann auf der Anschlussschicht 13, zum Beispiel mittels Aufdampfen oder Sputtern, abgeschieden werden.

Zur Befestigung des Halbleiterkörpers 2 auf dem Träger 15 ist zwischen der Spiegelschicht 14 und dem Träger eine, vorzugsweise elektrisch leitfähige, Verbindungsschicht 16 angeordnet. Die Verbindungsschicht 16 kann als Lotschicht oder elektrisch leitfähige Klebeschicht, zum Beispiel als Silberleitkleberschicht, ausgebildet sein.

Auf der Oberseite 4 des Halbleiterkörpers 2, insbesondere auf der vom Halbleiterkörper abgewandten Seite der ersten Anschlussschicht 12, ist ein Anschluss 18, zum Beispiel eine Anschlussmetallisierung, angeordnet. Der Anschluss 18 ist mit dem aktiven Bereich 3 über die erste Anschlussschicht 12 elektrisch leitend verbunden. Der Anschluss 18 ist vorzugsweise zur Verbindung mit einem Bonddraht ausgebildet.

Auf der vom aktiven Bereich 3 abgewandten Seite der zweiten Anschlussschicht 13, insbesondere auf der vom aktiven Bereich 3 abgewandten Seite des Trägers 15, ist ein Gegenanschluss 17 angeordnet. Der Gegenanschluss 17 ist mit dem aktiven Bereich über die Spiegelschicht 14 und insbesondere über die Verbindungsschicht 16 und den Träger 15 elektrisch leitend verbunden.

Über den Anschluss 18 und den Gegenanschluss 17 kann der aktive Bereich 3 elektrisch kontaktiert werden. Der Tunnelübergang 8 ermöglicht dabei einen barrierearmen Ladungsträgertransport von den Anschlüssen 17, 18 zum aktiven Bereich 3 trotz der Kontaktschichten 6 und 7 vom gleichen Leitungstyp.

Die oberseitige Anschlussschicht 12 ist vorzugsweise als Stromaufweitungsschicht ausgebildet. Über den auskoppelseitig angeordneten Anschluss 18 in die erste Anschlussschicht 12 injizierte Ladungsträger können in der Stromaufweitungsschicht in lateraler Richtung verteilt werden. Verglichen mit der relativ kleinflächigen Ausführung des Anschlusses 18 kann über die Stromaufweitung eine großflächigere Ladungsträgerinjektion in den Halbleiterkörper erzielt werden.

Die zweite Anschlussschicht 13 dient hauptsächlich der elektrischen Kontaktbildung zum Halbleiterkörper. Eine Stromaufweitung ist aufgrund der großflächig ausgebildeten und elektrisch leitfähigen Spiegelschicht 14 nicht erforderlich. Der Strom kann bereits über die Spiegelschicht großflächig in die unterseitige Anschlussschicht injiziert werden. Eine laterale Verteilung des Stroms über die Unterseite des Halbleiterkörpers wird demnach bereits auf der dem Halbleiterkörper abgewandten Seite der Anschlussschicht 13 erzielt.

Für eine Stromaufweitungsschicht, in der Ladungsträger lateral verteilt werden, eignet sich besonders eine Anschlussschicht einer Dicke von 200 nm oder größer. Die erste Anschlussschicht 12 weist daher bevorzugt eine Dicke von 200 nm oder mehr, besonders bevorzugt von 300 nm oder mehr oder von 400 nm oder mehr auf.

Für die Ausbildung eines elektrischen Kontaktes ohne maßgebliche Stromaufweitung dagegen kann bereits eine Anschlussschicht einer geringeren Dicke, zum Beispiel von 100 nm oder weniger, ausreichend sein. Da der Strom seitens der Unterseite 5 über den großflächigen Gegenanschluss 17 und die großflächige Spiegelschicht 14 bereits großflächig in den Halbleiterkörper gelangen kann, ist eine Stromaufweitung auf dieser Seite nicht von besonderem Vorteil. Die zweite Anschlussschicht 13 kann daher unter diesem Gesichtspunkt vergleichsweise dünn ausgeführt werden und z.B. eine Dicke von 150 nm oder weniger, besonders bevorzugt von 100 nm oder weniger aufweisen.

Es hat sich herausgestellt, dass eine vergleichsweise dicke zweite Anschlussschicht für das Erzielen einer hohen integralen Reflektivität (Gesamtreflektivität) einer Spiegelstruktur, die die zweite Anschlussschicht 13 und die Spiegelschicht 14 umfasst, besonders vorteilhaft ist. Eine vergleichsweise dünne zweite Anschlussschicht 13 kann Resonanzeffekte (mit)verursachen, die zu Inhomogenitäten in der Abhängigkeit der Reflektivität der Spiegelstruktur vom Einfallswinkel von Strahlung auf die Spiegelstruktur führen können. Für eine homogenere, also vom Einfallswinkel unabhängigere, integrale Reflektivität der Spiegelstruktur hat sich eine Dicke der zweiten Anschlussschicht von 400 nm oder mehr, bevorzugt von 500 nm oder mehr, als besonders vorteilhaft erwiesen. Der Einfluss von Resonanzeffekten auf die integrale Reflektivität kann so gemindert werden.

Auf der Auskoppelseite sollte die Fläche des Anschlusses 18 vergleichsweise gering gehalten werden, um die im Anschluss 18 absorbierte Strahlungsleistung nicht unnötig zu vergrößern. Eine Stromaufweitung in einer strahlungsdurchlässigen Anschlussschicht bringt daher auf dieser Seite des Halbleiterkörpers erhebliche Vorteile mit sich.

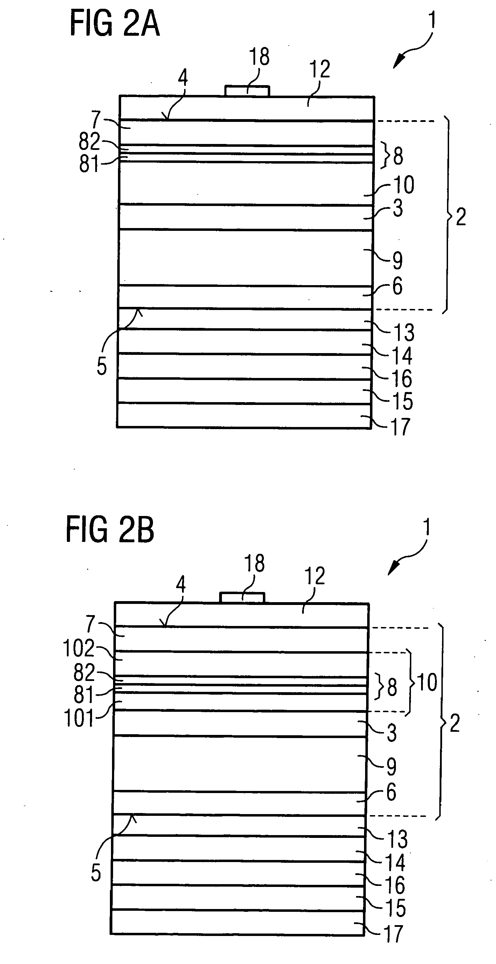

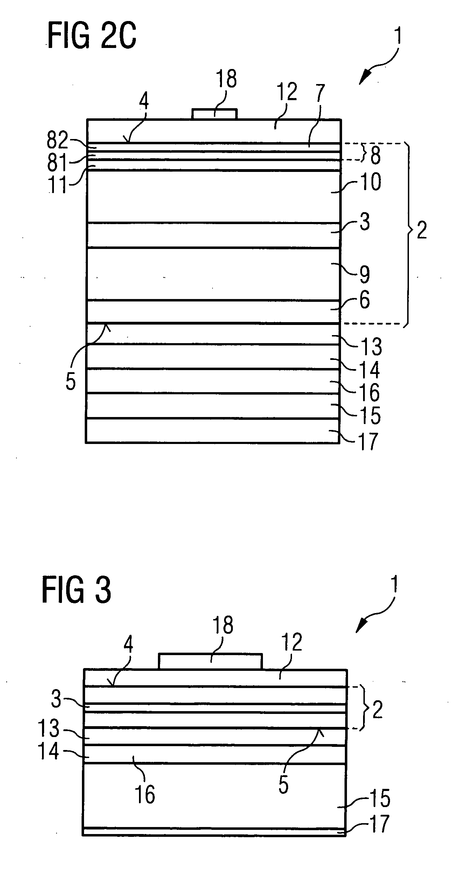

Figur 2 zeigt drei weitere Ausführungsbeispiele von erfindungsgemäßen Halbleiterchips anhand der in den Figuren 2A, 2B und 2C dargestellten schematischen Schnittansichten.

Die in Figur 2 dargestellten Halbleiterchips entsprechen im wesentlichen den jeweils gleichartig bezeichneten Figuren in Figur 1, das heißt Figur 2A entspricht Figur 1A, Figur 2B entspricht 1B und Figur 2C entspricht Figur 1C. Im Unterschied zu Figur 1 ist bei den Halbleiterchips 1 gemäß Figur 2 der Tunnelübergang 8 zwischen der ersten Anschlussschicht 12 und dem aktiven Bereich 3 und insbesondere auf der von der Spiegelschicht 14 abgewandten Seite des aktiven Bereichs 3 angeordnet.

Die Halbleiterkörper 2 gemäß Figur 2 weisen von der Unterseite 5 aus gesehen die gleiche Schichtabfolge auf wie die entsprechenden Halbleiterkörper 2 in Figur 1 von der Oberseite aus gesehen. Die Halbleiterkörper gemäß Figur 2 sind demnach gegenüber den entsprechenden Halbleiterkörpern aus Figur 1 umgekehrt auf der Spiegelschicht angeordnet.

Figur 3 zeigt eine vereinfachte Darstellung eines Halbleiterchips 1 anhand einer schematischen Schnittansicht. Der Halbleiterchip entspricht dabei im Wesentlichen den im Zusammenhang mit den Figuren 1 und 2 beschriebenen Halbleiterchips, wobei aus Übersichtlichkeitsgründen auf eine detaillierte Darstellung einzelner Elemente des Halbleiterkörpers 2 und Einzeldarstellungen der Spiegelschicht 14 und der Verbindungsschicht 16.verzichtet wurde. Der Halbleiterkörper 2 kann dabei entsprechend den im Zusammenhang mit den Figuren 1 und 2 beschriebenen Halbleiterkörpern ausgeführt sein.

Im Bereich unterhalb des kleinflächigen Anschlusses 18, der beispielsweise als Bondpad ausgeführt ist, in den Halbleiterkörper 2 gelangende Ladungsträger führen im aktiven Bereich vermehrt zu einer Strahlungserzeugung unterhalb dieses Anschlusses. Der unterhalb des Anschlusses 18 erzeugte Strahlungsanteil wird in der Regel zu einem nicht unerheblichen Anteil in diesem Anschluss absorbiert.

Zur Erhöhung der Auskoppeleffizienz des Halbleiterchips 1 ist es daher vorteilhaft, eine Strahlungserzeugung im vom Anschluss 18 überdeckten Gebiet des aktiven Bereichs 3 gezielt zu vermindern. Unter Auskoppeleffizienz ist hierbei das Verhältnis der im Halbleiterkörper erzeugten Strahlungsleitung zu der aus dem Halbleiterchip ausgekoppelten Strahlungsleistung zu verstehen.

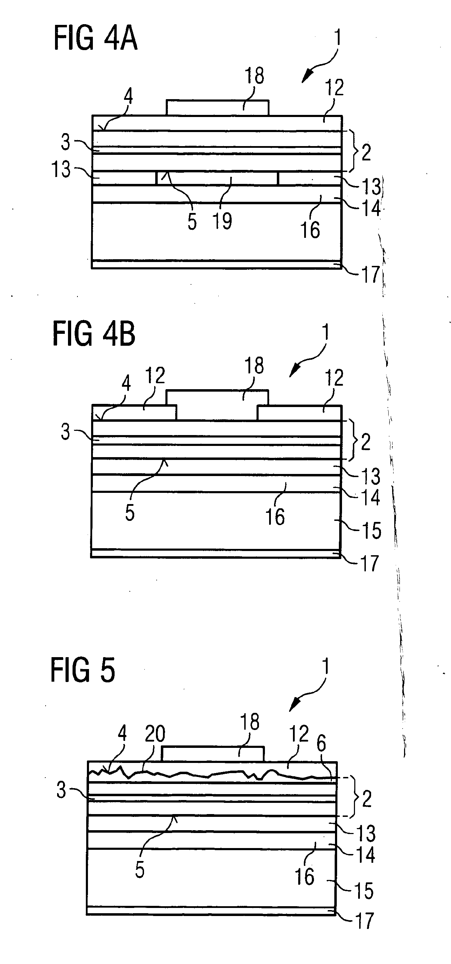

Hierfür geeignete Maßnahmen sind im Zusammenhang mit Figur 4 näher erläutert.

Figur 4 zeigt zwei weitere Ausführungsbeispiele von Halbleiterchips 1 anhand der schematischen Schnittansichten in den Figuren 4A und 4B. Diese Ansichten entsprechen im wesentlichen der vereinfachten Ansicht aus Figur 3. Im Unterschied hierzu sind diese Chips derart ausgebildet, dass eine Strahlungserzeugung unterhalb des Anschlusses 18 vermindert ist.

Der in Figur 4A gezeigte Halbleiterchip 1 weist auf der dem Anschluss 18 abgewandten Seite des aktiven Bereichs 3 ein Isoliermittel auf, das eine Ladungsträgerinjektion in den aktiven Bereich in dem vom Anschluss 18 überdeckten Gebiet vermindert.

Als Isoliermittel ist auf der dem Anschluss 18 abgewandten Seite des aktiven Bereichs eine elektrische Isolierschicht 19, beispielsweise eine Siliziumnitridschicht, auf den Halbleiterkörper aufgebracht, insbesondere abgeschieden. Die Isolierschicht 19 überdeckt den Anschluss 18 bevorzugt vollständig und ist besonders bevorzugt gegenüber dem Anschluss 18 lateral verbreitert. Die Isolierschicht 19 ist mit Vorzug zwischen dem aktiven Bereich 3 und der Spiegelschicht 14 angeordnet.

Mittels der Isolierschicht 19 kann die Injektion von Ladungsträgern in den Halbleiterkörper im Bereich unterhalb des Anschlusses 18 gemindert werden. Hierdurch wird die im Bereich unterhalb des Anschlusses erzeugte Strahlungsleistung und dementsprechend auch die im Anschluss 18 absorbierbare Strahlungsleistung vorteilhaft verringert.

Durch die laterale Verbreiterung der Isolierschicht 19 gegenüber der Abmessung des Anschlusses 18 kann das Eintreten von Ladungsträgern aufgrund der Stromaufweitung im Halbleiterkörper in das Gebiet unterhalb des Anschlusses vermindert werden.

Die Isolierschicht 19 ist vorzugsweise in einer Aussparung der unterseitigen zweiten Anschlussschicht 13 angeordnet. Der direkte Strompfad zwischen der Spiegelschicht 14 und dem vom Anschluss 18 überdeckten Gebiet des aktiven Bereichs 3 wird somit im Bereich der Isolierschicht unterbrochen.

Die Strahlungserzeugung im aktiven Bereich wird in der Folge auf nicht vom Anschluss 18 überdeckte Bereiche konzentriert. Die im Anschluss 18 absorbierbare Strahlungsleistung wird hierdurch vorteilhaft verringert. Insgesamt kann so die über die vom aktiven Bereich 3 abgewandte Seite der ersten Anschlussschicht 12 austretende Strahlungsleistung erhöht werden.

Alternativ oder ergänzend zur Ausbildung eines unterseitigen (vergrabenen) Isoliermittels, wie im Zusammenhang mit Figur 4A beschrieben, kann auch oberseitig ein Isoliermittel ausgebildet sein, Figur 4B.

Beispielsweise kann die Ladungsträgereinprägung unterhalb des Anschlusses 18 in den Halbleiterkörper 2 über eine Isolierschicht, die zwischen dem Anschluss 18 und dem Halbleiterkörper angeordnet ist, gemindert werden (nicht explizit dargestellt).

Bei einem direkten mechanischen Kontakt des Anschlusses 18 zum Halbleiterkörper 2 kann durch geeignete Auswahl des seitens des Halbleiterkörpers an den Anschluss angrenzenden Materials eine Ladungsträgerinjektion im mechanischen Kontaktbereich des Anschlusses zum Halbleiterkörper vermindert werden. Beispielsweise kann die erste Anschlussschicht 12 mit einer Aussparung ausgebildet sein, in die der Anschluss 18 eingebracht ist. Randseitig in der Ausnehmung und vorzugsweise auch auf der vom Halbleiterkörper 2 abgewandten Seite der Anschlussschicht 12 ist der Anschluss 18 mit der Anschlussschicht, insbesondere unmittelbar, elektrisch leitend verbunden. Am Boden der Aussparung grenzt der Anschluss 18 unmittelbar an den Halbleiterkörper an.

Um die Ladungsträgerinjektion unterhalb des Anschlusses 18 zu vermindern kann zum Beispiel seitens des Halbleiterkörpers ein Metall für den Anschluss 18 eingesetzt werden, das mit dem seitens des Halbleiterkörpers angrenzenden Material eine Schottky-Barriere ausbildet. Auch das Ausbilden einer Zone hohen Widerstandes im Halbleiterkörper 2 im Kontaktbereich des Halbleiterkörpers zum Anschluss 18, zum Beispiel durch Implantation in den Halbleiterkörper, etwa Protonenimplantation, ist hierzu geeignet. Ladungsträger gelangen dann vom Gegenanschluss ausgehend überwiegend über die erste Anschlussschicht 12 in den Halbleiterkörper 2. Eine direkte Ladungsträgerinjektion in den Halbleiterkörper über den Anschluss 18 wird in der Folge vermindert.

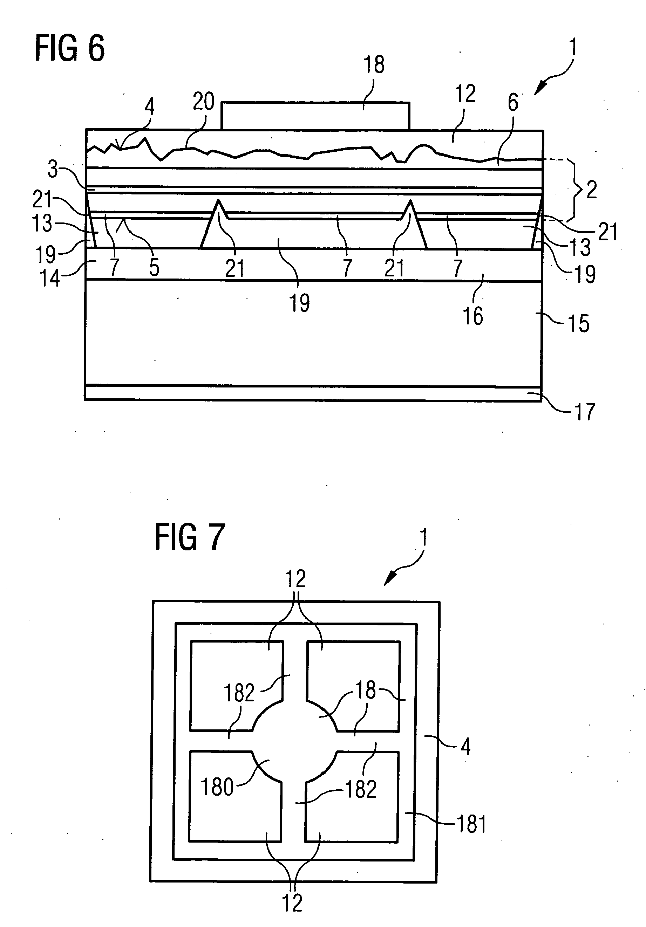

Figur 5 zeigt ein weiteres Ausführungsbeispiel eines Halbleiterchips 1 anhand einer schematischen Schnittansicht. Der Halbleiterchip entspricht im Wesentlichen den im Zusammenhang mit den vorherigen Figuren 1 bis 3 beschriebenen Halbleiterchips.

Im Unterschied hierzu ist der Halbleiterkörper 2 mit einer Oberflächenstruktur 20 versehen. Vorzugsweise ist die Oberflächenstruktur oberseitig, insbesondere auf der von der Spiegelschicht abgewandten Seite des Halbleiterkörpers 2 ausgebildet. Über die Oberflächenstruktur 20 kann die aus dem Halbleiterkörper seitens der strukturierten Fläche ausgekoppelte Strahlungsleistung erhöht werden.

Mittels einer derartigen Auskoppelstruktur, die beispielsweise als Aufrauung ausgeführt sein kann., kann die Reflexion., insbesondere die Totalreflexion, an der strukturierten Oberfläche des Halbleiterkörpers 2 gestört werden. Der Durchtritt von Strahlung durch diese Oberfläche wird so erleichtert.

Die Oberflächenstruktur 20 kann insbesondere in der jeweiligen oberseitigen Kontaktschicht (in Figur 5 für die Kontaktschicht 6 gezeigt) ausgebildet sein. Diese Kontaktschicht sorgt damit zugleich für einen guten elektrischen Kontakt zur Anschlussschicht und trägt zur Erhöhung der aus dem Halbleiterkörper 2 ausgekoppelten Strahlungsleistung bei. Eine derartige Auskoppelstruktur kann mittels Aufrauen des Halbleiterkörpers, zum Beispiel durch Ätzen, erzeugt sein.

Figur 6 zeigt ein weiteres Ausführungsbeispiel eines Halbleiterchips 1 anhand einer schematischen Schnittansicht. Der Halbleiterchip entspricht im wesentlichen den im Zusammenhang mit den Figuren 4A und 5 beschriebenen Halbleiterchips.

Im Unterschied hierzu weist der Halbleiterkörper 2 des Chips seitens der Unterseite 5 eine oder eine Mehrzahl von Ausnehmungen 21 auf. Die Ausnehmung 21 erstreckt sich von der Unterseite 5 des Halbleiterkörpers 2 in Richtung des aktiven Bereichs 3, durchbricht diesen jedoch vorzugsweise nicht. Die Ausnehmung 21 weist vorzugsweise eine schräg stehende Seitenfläche auf. Vom aktiven Bereich 3 aus auf die Seitenfläche der Ausnehmung treffende Strahlung kann an dieser Fläche reflektiert werden. Aufgrund der angeschrägten Ausbildung der Ausnehmung kann die Reflexionswinkelverteilung von Strahlung im Halbleiterkörper 2 gegenüber einer ebenen. Ausführung der Unterseite 5 breiter gestreut werden. Die Austrittswahrscheinlichkeit von Strahlung aus dem Halbleiterkörper wird in der Folge erhöht. Insbesondere kann die jeweilige Ausnehmung 21 mit dem Isolationsmaterial der Isolationsschicht 19 befüllt sein. Hierüber kann gleichzeitig die Ladungsträgerinjektion unterhalb des Anschlusses 18 in den aktiven Bereich 3 gemindert werden.

Auch im Randbereich des Halbleiterkörpers weist dieser vorzugsweise eine Ausnehmung 21 auf, welche zweckmäßigerweise mit dem Isolationsmaterial befüllt ist. Im Randbereich des aktiven Bereichs ist die Gefahr einer nicht-strahlenden Rekombination von Ladungsträgern besonders groß. Durch eine Verminderung der randseitigen Ladungsträgerinjektion in den Halbleiterkörper kann der Anteil an nicht-strahlend rekombinierenden Ladungsträgern reduziert und in der Folge die Effizienz des Halbleiterkörpers erhöht werden.

Mittels der Ausnehmung(en) kann insbesondere eine mikroprismenartige Struktur im Halbleiterkörper ausgebildet sein.

Seitens der Oberseite 4 weist der Halbleiterkörper 2 eine Auskoppelstruktur 20 entsprechend dem in Figur 5 dargestellten Halbleiterchip auf.

Figur 7 zeigt ein Ausführungsbeispiel eines Halbleiterchips 1 anhand.einer schematischen Aufsicht auf die erste Anschlussschicht 12 seitens der Oberseite 4. Der Anschluss 18 ist hierbei als Anschlussstruktur ausgeführt, die außer einem Anschlussbereich 180 vorzugsweise einen randseitig ausgebildeten Rahmen 181 aufweist. Der Rahmen umläuft die Oberseite 4 des Halbleiterkörpers und insbesondere den Anschlussbereich vorzugsweise lateral. Über Verbindungsstege 182 ist der Rahmen 181 mit dem Anschlussbereich 180 elektrisch leitend verbunden. Durch diese, sich lateral weitläufig über den Halbleiterkörper erstreckende Anschlüssstruktur kann.- insbesondere zusätzlich zu einer Stromaufweitung in der ersten Anschlussschicht - eine laterale Stromverteilung über die Oberseite 4 des Halbleiterkörpers erzielt werden. Der Anschlussbereich 180 ist vorzugsweise zur Drahtbondung, also zur elektrisch leitenden Verbindung mit einen Bonddraht vorgesehen. Weiterhin ist der Anschlussbereich 180 vorzugsweise mittig auf der Oberseite vorgesehen.

Eine derartige Anschlussstruktur kann bei den im Zusammenhang mit den vorhergehenden Figuren beschriebenen Halbleiterchips eingesetzt werden.

Aufgrund der ausgesparten, insbesondere gitterartigen, Ausbildung des Anschlusses 18 ist ein Strahlungsaustritt aus dem Halbleiterchip durch den ausgesparten Bereich, insbesondere in den Gitterlücken, mit Vorteil nicht durch Absorption im Anschluss 18 gemindert. Über Stromaufweitung in der Anschlussschicht 12 können mit Vorteil auch in den nicht von der Anschlussstruktur überdeckten Bereichen vermehrt Ladungsträger in den Halbleiterkörper gelangen.

Die Erfindung ist nicht durch die Beschreibung anhand der Ausführungsbei.spiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder den Ausführungsbeispielen angegeben ist.

Insbesondere kann die Erfindung auch bei Halbleiterkörpern Anwendung finden, die auf dem III-V-Materialsystem Inₓ Ga_{y} Al_{1-x-y} N oder Inₓ Ga_{y} Al_{1-x-y} As basieren, jeweils mit 0≤x≤1, 0≤y≤1 und x+y≤1, wobei bevorzugt jeweils y≠0, y≠1, x≠0 und/oder x≠1 ist.

## Patentansprüche

1. Halbleiterkörper (2), der eine Halbleiterschichtenfolge mit einem zur Strahlungserzeugung geeigneten aktiven Bereich (3) umfasst, wobei
die Halbleiterschichtenfolge zwei Kontaktschichten (6, 7) umfasst, zwischen denen der aktive Bereich angeordnet ist, den Kontaktschichten jeweils eine auf dem Halbleiterkörper angeordnete Anschlussschicht (12, 13) zugeordnet ist,
die jeweilige Anschlussschicht mit der zugeordneten Kontaktschicht elektrisch leitend verbunden ist,
die jeweilige Anschlussschicht auf der von dem aktiven. Bereich abgewandten Seite der zugeordneten Kontaktschicht angeordnet ist,
die Anschlussschichten für die in dem aktiven Bereich zu erzeugende Strahlung durchlässig sind, und
die Kontaktschichten vom gleichen Leitungstyp sind.

2. Halbleiterkörper nach Anspruch 1,
bei dem der aktive Bereich (3) zwischen den Anschlussschichten (12, 13) angeordnet ist.

3. Halbleiterkörper nach Anspruch 1 oder 2,
bei dem die Anschlussschichten (12, 13) ein strahlungsdurchlässiges und elektrisch leitfähiges Oxid enthalten.

4. Halbleiterkörper nach mindestens einem der vorhergehenden Ansprüche,
bei dem die Anschlussschichten (12, 13) gleiche Materialien enthalten.

5. Halbleiterkörper nach Anspruch 3 oder 4,
bei dem beide Anschlussschichten (12, 13) Zinkoxid enthalten.

6. Halbleiterkörper nach Anspruch 3 oder 4,
bei dem beide Anschlussschichten (12, 13) Indiumzinnoxid enthalten.

7. Halbleiterkörper nach mindestens einem der vorhergehenden Ansprüche,
bei dem die eine Anschlussschicht (12) an die eine Kontaktschicht (6) und die andere Anschlussschicht (13) an die andere Kontaktschicht (7) angrenzt.

8. Halbleiterkörper nach mindestens einem der vorhergehenden Ansprüche,
bei dem beide Kontaktschichten (6, 7) p-leitend ausgeführt sind.

9. Halbleiterkörper nach mindestens einem der vorhergehenden Ansprüche,
bei dem eine der Kontaktschichten (6, 7) GaAs oder AlGaAs enthält oder die Kontaktschichten GaAs oder AlGaAs enthalten.

10. Halbleiterkörper nach mindestens einem der vorhergehenden Ansprüche,
bei dem der aktive Bereich (3) ein Material aus dem Materialsystem Inₓ Ga_{y} Al_{1-x-y} P, mit 0≤x≤1, 0≤y≤1 und x+y≤1, enthält.

11. Halbleiterkörper nach mindestens einem der vorhergehenden Ansprüche,
bei dem zwischen einer der Anschlussschichten (12, 13) und dem aktiven Bereich ein Tunnelübergang (8) angeordnet ist.

12. Halbleiterkörper nach Anspruch 11,
bei dem der Tunnelübergang (8) in der Halbleiterschichtenfolge integriert ist und zwei Tunnelschichten (81, 82) unterschiedlichen Leitungstyps umfasst.

13. Halbleiterkörper nach Anspruch 11 oder 12,
bei dem eine von dem aktiven Bereich (3) abgewandte Tunnelschicht (81, 82) des Tunnelübergangs (8) als eine der Kontaktschichten (6, 7) ausgebildet ist oder bei dem eine von dem aktiven Bereich abgewandte Tunnelschicht des Tunnelübergangs den gleichen Leitungstyp wie die Kontaktschichten aufweist.

14. Halbleiterkörper nach mindestens einem der vorhergehenden Ansprüche,
bei dem auf der von dem Halbleiterkörper (2) abgewandten Seite einer der Anschlussschichten (13) eine Spiegelschicht (14) angeordnet ist.

15. Halbleiterkörper nach mindestens einem der Ansprüche 11 bis 14,
bei dem der Tunnelübergang (8) zwischen der Spiegelschicht (14) und dem aktiven Bereich (3) angeordnet ist.

16. Halbleiterkörper nach mindestens einem der Ansprüche 11 bis 14,
bei dem der Tunnelübergang (8) auf der von der Spiegelschicht (14) abgewandten Seite des aktiven Bereichs.(3) angeordnet ist.

17. Halbleiterkörper nach mindestens einem der Ansprüche 10 bis 15,
bei dem die Spiegelschicht (14) Au enthält.

18. Halbleiterkörper nach mindestens einem der vorhergehenden Ansprüche,
bei dem der Halbleiterkörper als Dünnfilm-Halbleiterkörper ausgeführt ist.

19. Halbleiterkörper nach mindestens einem der vorhergehenden Ansprüche,
der als Lumineszenzdioden-Halbleiterkörper (2) ausgeführt ist.

20. Halbleiterchip,
der einen Halbleiterkörper (2) nach einem der vorhergehenden Ansprüche und einen Träger (15) umfasst, wobei der Halbleiterkörper auf dem Träger angeordnet ist.

21. Halbleiterchip nach Anspruch 20,
bei dem der Träger von einem Aufwachssubstrat der Halbleiterschichtenfolge verschieden ist.
